Europäisches Patentamt

European Patent Office

Office européen des brevets

(19)

(11) **EP 1 291 781 A1**

(12) **DEMANDE DE BREVET EUROPEEN**

(43) Date de publication:
**12.03.2003 Bulletin 2003/11**

(51) Int Cl.⁷: **G06F 13/40**, H03K 19/0948

(21) Numéro de dépôt: **02368096.0**

(22) Date de dépôt: **06.09.2002**

(84) Etats contractants désignés:
**AT BE BG CH CY CZ DE DK EE ES FI FR GB GR
IE IT LI LU MC NL PT SE SK TR**
Etats d'extension désignés:
**AL LT LV MK RO SI**

(30) Priorité: **07.09.2001 FR 0111567**

(71) Demandeur: **STMicroelectronics S.A.
92120 Montrouge (FR)**

(72) Inventeur: **Caranana, Joel
38210 Polienas (FR)**

(74) Mandataire: **Schuffenecker, Thierry
97, chemin de Cassiopée,
Domaine de l'étoile
06610 La Gaude (FR)**

(54) **Circuit de commande de bus**

(57)    Une Interface de bus comportant un premier circuit basée sur une première paire de transistors (10, 20) de type opposés présentant une électrode de commande et une électrode commune destinée à fournir à premier potentiel de sortie (D+). Un second circuit comporte une seconde paire de transistors (30, 40) de type opposés au présent et qui présentant une électrode commune destinée à fournir un second potentiel (D-) commutant dans un sens inverse au précédent. Le dispositif comporte des premiers moyens de couplage capacitifs destinés à réinjecter une fraction du signal existant audit premier potentiel (D+) dans lesdites électrode de commandes de ladite seconde paire de transistors et des seconds moyens de couplage capacitifs destinés à réinjecter une fraction du signal existant audit second potentiel (D-) dans lesdites électrodes de commande de ladite première paire de transistor. On arrive ainsi à compenser les décalage de temps de montée et de descente des transistors de chaque paire.

Figure 2

EP 1 291 781 A1

## Description

### Domaine technique de l'invention

La présente invention concerne les circuits de commande de bus, et notamment un circuit de commande de bus doté d'un dispositif d'asservissement des temps de commutation.

### Etat de la technique

Les systèmes de communication se développent sans cesse et les vitesses de fonctionnement s'accroissent constamment. Les circuits de commande de bus - également connus sous la dénomination anglosaxonne de *drivers* ou *buffers* fonctionnent à des vitesse de plus en plus importantes.

Un exemple typique apparaît avec l'interface série définie dans la norme CCITT - *Universel Serial Bus* qui est destiné à régir le fonctionnement de l'interface série entre des systèmes de traitement de données, et notamment des périphériques d'ordinateurs. Dans l'une des versions les plus récentes de cette norme - à savoir la norme dite USB 2.0, les circuits de commande de bus sont prévus pour fonctionner à trois vitesses différentes, à savoir une vitesse basse (« *low speed* »), moyenne (« *full speed* ») et haute (« *high speed'*). La vitesse moyenne - « full speed » - est envisagée à 12 Mbits par secondes et la norme impose des contraintes particulièrement sévères notamment aux niveaux des temps de commutation des deux circuits de sorties (ou « *buffers* ») attaquant le câble série.

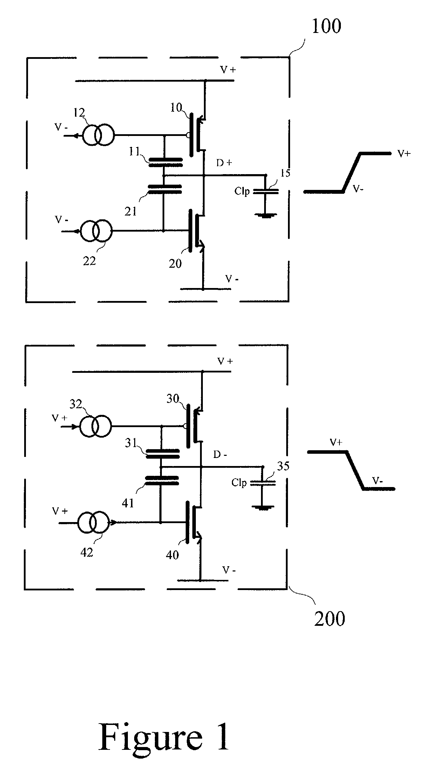

La figure 1 montre une architecture classique pour un tel circuit de commande comportant un double circuit de commande présentant d'impédance faible - typiquement 6 ohms - commutant à 6 Mhz par exemple sur des charges capacitives de 50 picoFahrads.

Un premier circuit de commande ou *driver 100* est basé autour d'une paire de transistors NMOS-PMOS composée respectivement du transistor PMOS 10 et du transistor NMOS 20 dont les drains sont connectés à une électrode D+ commune. Chacun des transistors 10 et 20 présente un condensateur dit de couplage - respectivement 11 et 21 - qui permet de fixer en valeur absolue les temps de montée et de descente du potentiel de sortie à la borne D+ chargé par un condensateur $C_{LP}$ 15. Les grilles des transistors 10 et 20 sont respectivement commandés par un générateur de courant, respectivement 12 et 22.

D'une manière similaire, le circuit de commande comporte un second circuit 200 qui est basé d'une manière similaire sur une paire de transistors NMOS-PMOS composée des transistors 30 et 40 commandés par les sources de courant 32 et 42 respectivement, et associés à un condensateur de couplage 31 et 41 respectivement. La jonction commune du transistor PMOS 30 et du transistor NMOS 40 fournit un potentiel dit D- - auquel se trouve connecté une charge (supposée capacitive) $C_{LP}$ 35 - et qui est prévu pour commuter exactement à l'inverse du potentiel commun D+ des transistors 10 et 20.

L'ensemble des deux circuits 100 et 200 permet de constituer une double structure de commande pour un bus. On s'aperçoit cependant que l'on a du mal à apparier les caractéristiques des transistors NMOS et PMOS de manière à assurer, au niveau des potentiels D+ et D-, des temps de montée (*rise time*) et de descente (*fall time*) qui soient sensiblement identiques. On a de grandes difficultés au niveau des procédés de fabrication pour apparier des transistors NMOS et PMOS de manière à ce que ceux-ci présentent des caractéristiques internes sensiblement similaires comme on arrive à le faire courrament, par exemple, avec des résistances ou des condensateurs.

Le problème à résoudre par l'objet de la présente demande consiste à réaliser une structure simple de circuit de commande, par exemple pour un circuit d'interfaçage série de type U.S.B., qui permettent de compenser les différences au niveau des composants actifs, et notamment NMOS et PMOS et d'apparier sensiblement les temps de commutation, notamment de montée et de descente, des transistors.

### Exposé de l'invention

La présente invention a pour but de proposer une structure de commande ou d'interfaçage pour un câble série qui présente des valeurs de temps de montée et de descente sensiblement identiques.

C'est un objet de la présente demande de réaliser un circuit d'interfaçage pour un port série U.S.B. qui permette le fonctionnement en mode moyenne vitesse.

L'invention réalise ces buts au moyen d'un circuit d'interfaçage de bus qui comporte :

- un premier circuit comportant une première paire de transistors de type opposés présentant une électrode de commande et une électrode commune destinée à fournir à premier potentiel de sortie (D+) ;
- un second circuit comportant une seconde paire de transistors de type opposés et présentant une électrode commune destinée à fournir un second potentiel (D-) commutant dans un sens inverse au précédent ;
- des premiers moyens de couplage capacitifs destinés à réinjecter une fraction du signal existant audit premier potentiel (D+) dans lesdites électrode de commandes de ladite seconde paire de transistors et,
- des seconds moyens de couplage capacitifs destinés à réinjecter une fraction du signal existant audit second potentiel (D-) dans lesdites électrodes de commande de ladite première paire de transistor de manière à provoquer une compensation des caractéristiques internes des transistors et à uniformiser les temps de montée et de descente.

Préférentiellement, le couplage sera réalisé au moyen de condensateur de couplage croisé et on pourra alors, au prix d'un simple appariement de condensateurs qui reste facile à réaliser, compenser les écarts au niveau des caractéristiques internes des transistors NMOS et PMOS et obtenir des temps de montée et de descente sensiblement identiques.

Dans un mode de réalisation préféré, la première paire de transistors comporte un premier transistor de type PMOS dont l'électrode de source est connectée à un potentiel positif (V+) et qui reçoit sur sa grille un signal de commande. Un second transistor de type NMOS présente une électrode de source connectée à un potentiel négatif (V -) et reçevant également à sa grille un signal de commande. Les deux électrodes de drain des premier et second transistors sont connectées conjointement de manière à fournir le potentiel sur l'électrode de sortie (D+). Un premier condensateur de couplage est respectivement connecté entre la grille et le drain du premier transistor et, de la même façon, un second condensateur de couplage est inséré entre la grille et le drain du second transistor. On réalise alors le couplage capacitif croisé au moyen d'un premier et second condensateur de couplage croisé, dont l'une des électrodes est connectée au potentiel de sortie (D-) du second circuit de commande et dont la seconde électrode est respectivement connectée à la grille du premier transistor et la grille du second transistor.

Le second circuit comporte un troisième transistor de type PMOS ayant une électrode de grille ayant une électrode de source connectée à un potentiel positif (V+). Le troisième transistor est monté en série avec un quatrième transistor de type NMOS dont l'électrode de source est connectée à un potentiel négatif (V-) et présentant une électrode de drain commune avec le troisième transistor, cette électrode commune étant connectée au potentiel de sortie (D-). Un quatrième transistor de type NMOS présente une électrode de source connectée à un potentiel négatif (V -) et reçevant sur sa grille un signal de commande. Un troisième condensateur de couplage de sortie est connecté entre la grille et le drain du troisième transistor et, de la même manière, un quatrième condensateur de couplage de sortie est connecté entre la grille et le drain du quatrième transistor.

On réalise alors le couplage capacitif croisé au moyen d'un troisième et quatrième condensateur de couplage croisé présentant chacun une première électrode connectée au potentiel de sortie (D+) du premier circuit de commande et une seconde électrode qui est respectivement connectée à la grille du troisième et la grille du quatrième transistor.

Dans un mode de réalisation préféré, on ajustera les valeurs des quatre condensateurs de couplage croisé $C_1$, $C_2$, $C_3$ et $C_4$ suivant les formules données ci-

après :

$$C_1 = K \times C_2$$

$$C_3 = C_1$$

$$C_4 = C_2$$

Dans lesquelles K correspond au rapport des valeurs des courants de polarisation dans les sources 12 et 42 respectivement.

Alternativement, on pourra réaliser une structure duale dans laquelle, le premier, le second, le troisième et le quatrième transistor seront respectivement de type NMOS, PMOS, NMOS et PMOS.

Préférentiellement, on associera au circuit de commande un dispositif permettant d'éviter la conduction simultanée des transistors de la première et de la seconde paire afin d'éviter une surconsommation d'énergie.

Dans un mode de réalisation préféré, on réalisera avantageusement les condensateurs de couplage croisé entre le premier et le second circuit au moyen de techniques de fabrication basées sur des matrices de capacités.

**Description des dessins**

La figure 1 illustre la structure d'un circuit de commande ou de driver connu dans l'état de la technique.

La figure 2 illustre le circuit de commande amélioré par l'enseignement de la présente invention.

**Description d'un mode de réalisation préféré**

On décrira à présent un mode de réalisation préféré, lequel servira à constituer un circuit d'interfaçage pour un port série de type U.S.B. Il est clair cependant que l'invention pourra permettre la réalisation de tout autre circuit d'interface à haute vitesse. De la même manière, pour faciliter la compréhension de l'invention, on décrira une structure comparable à celle du circuit connu présenté dans la figure 1, c'est à dire avec des transistors NMOS dont l'électrode de source sera connecté à la masse et des transistors PMOS alimentés par une tension d'alimentation positive. L'homme du métier pourra évidemment adapter le circuit de manière à former une structure duale dans laquelle des transistors NMOS sont connectés à la masse et des transistors PMOS sont alimentés par une tension négative.

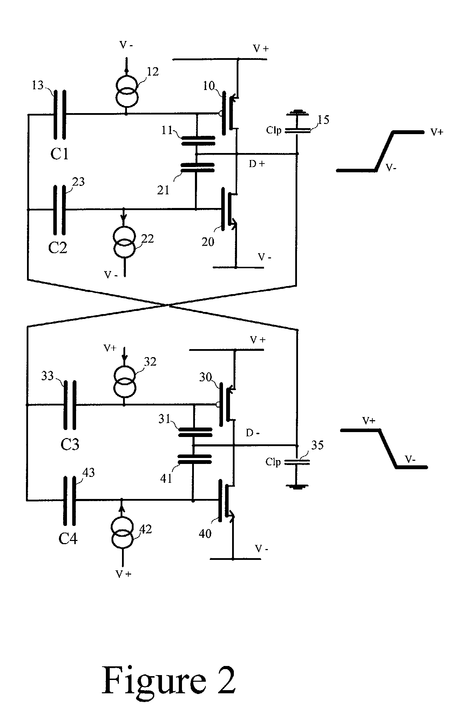

Si l'on examine plus en détail la structure de la figure 2, on observe que le premier circuit se compose d'un premier transistor PMOS 10 alimenté via son électrode de source par une tension d'alimentation positive V+ et présente une électrode de drain connecté à l'électrode de sortie D+ du circuit de commande de bus. Un transistor 20 de polarité opposée, de type NMOS, présente une électrode de drain connectée à l'électrode de sortie D+ et une électrode de source connectée à un potentiel de référence négatif V-. Les électrodes de grille des transistors 10 et 20 sont commandées par une source de courant, respectivement une première source 12 et une seconde source 22 alimentées par le potentiel V-. Comme cela est connu, on connecte habituellement un premier condensateur de couplage 11 entre la grille du transistor PMOS 10 et son électrode de drain. De la même manière, on insère un second condensateur de couplage entre la grille du transistor NMOS 20 et son électrode de drain. Dans le schéma de la figure 2, on suppose que l'électrode de sortie D+ se trouve connectée à une charge capacitive 15 ($C_{LP}$) qui est une représentation assez proche d'une charge typique pour une interface série. Il est clair cependant qu'il ne s'agit ici que d'une illustration qui ne saurait être nullement limitative.

Le second circuit se compose d'un troisième transistor 30, de même type que le transistor 10 et qui présente une électrode de source connectée au potentiel positif V+ et une électrode de drain connectée à l'électrode de sortie D - , laquelle se trouve chargée par une charge 35 supposée elle également de nature capacitive. Un quatrième transistor 40 - de même type que le second transistor NMOS 20 - présente une électrode de drain qui est connectée à l'électrode de sortie D - ainsi qu'une électrode de source qui est connectée au potentiel négatif V- . Les électrodes de grilles des transistors 10 et 20 sont respectivement commandées par une troisième source de courant 32 et une quatrième source de courant 42 (V+) supposées recevoir le signal de commutation. Comme pour la paire de transistors 10 et 20, on aménage un troisième condensateur de couplage 31 entre la grille du transistor PMOS 30 et son électrode de drain, et un quatrième condensateur de couplage 41 entre la grille et le drain du transistor NMOS 40.

Afin de compenser les différences de caractéristiques internes des paires de transistors 10-20 et 30-40 on réalise à présent d'une manière avantageuse un nouveau couplage capacitif croisé entre les deux circuit de commande 100 et 200, spécialement au moyen d'un jeu de quatre condensateurs 13, 23 , 33 et 43.

Plus précisément, on insère un premier condensateur 13 - présentant une valeur $C_1$ - entre l'électrode de grille du premier transistor PMOS 10 et la sortie D- - du circuit de commande de bus opposé. On insère de la même manière un second condensateur 23 - présentant une valeur $C_2$ - entre l'électrode de grille du second transistor NMOS 20 et la sortie D - de l'autre circuit de commande. On réalise de ce fait un premier couplage capacitif croisé entre les entrées de grilles des transistors 10 et 20 et la sortie du second circuit de commande de bus formé par la paire de transistors 30-40.

D'une manière symétrique, on réalise un second couplage capacitif croisé entre les entrées des grilles des transistors 30 et 40 et la sortie du premier circuit D+. On insère à cet effet un troisième condensateur 33 de valeur $C_3$ entre la grille du transistor 30 et la sortie D+ , et un quatrième condensateur 43 de valeur $C_4$ entre la grille du transistor 40 et la sortie D +. Les sources de courant 12, 22, 32 et 42 qui attaquaient respectivement les transistors 10, 20 , 30 et 40 restent pour leur part inchangées.

Comme on le voit sur la figure 2, les potentiels de sortie D+ et D- commutent en sens opposé. Les condensateurs de couplage croisé 13, 23, 33 et 43 permettent de réinjecter une partie de l'information existant au niveau de la sortie de l'un des circuits de commande - par exemple D + en sortie de la paire de transistors 10-20 - pour modifier le comportement de la paire de transistors de l'autre circuit (30 et 40 dans ce cas) . S'il s'avère que, en raison des caractéristiques internes des composants actifs, l'un des circuit commute plus rapidement que l'autre - par exemple la paire de transistor 10-20 -, le couplage croisé qui est réalisé vient alors accroître sensiblement la vitesse de commutation de la paire opposée, réduisant ainsi l'écart entre les temps de commutation des transistors.

On peut ainsi réaliser, grâce à ce couplage capacitif croisé une compensation efficace des caractéristiques internes des composants actifs 10, 20, 30 et 40 dont on connaît la difficulté d'appariement. Cette compensation est réalisée au moyen d'un appariement au niveau des composant passifs que constituent les quatre condensateurs 13, 23, 33 et 43, que l'on arrive plus facilement à réaliser sur le plan des procédés de fabrication.

D'une manière précise, on ajustera les valeurs des condensateurs $C_1$, $C_2$, $C_3$ et $C_4$ suivant les formules données ci-après :

$$C_1 = K \times C_2$$

$$C_3 = C_1$$

$$C_4 = C_2$$

Où $K = I_{12} / I_{42}$ avec $I_{12}$ et $I_{42}$ correspondant respectivement aux courants de polarisation dans les sources 12 et 42 respectivement. L'homme du métier pourra ensuite ajuster la valeur du condensateur $C_1$ (les autres valeurs étant alors déduites par les formules précédentes) de manière à fixer les valeurs des temps de montée et de descente aux valeurs souhaitées.

Comme on le voit, l'invention permet de compenser substantiellement les différences des caractéristiques internes existant au niveau des transistors 10, 20, 30 et 40, ceci au moyen d'un simple ajustement de valeurs de condensateurs. On notera que toutes les techniques connues d'appariement des valeurs de ces condensateur 13, 23, 33 et 43 pourront être avantageusement employées. Ainsi, l'homme du métier pourra avantageusement organiser sur l'élément semiconducteur les condensateurs 13, 23, 33 et 43 en matrices de condensateurs de manière à éviter les effets résultant des gradients de diffusion sur l'élément semiconducteur.

De la même manière, on observe que les circuits de commande attaquant les grilles des transistors pourront avantagement intégrer les dispositifs annexes connus que l'on emploie habituellement dans ce type de structure. Ainsi, on pourra clairement y adapter un circuit d'économie d'énergie permettant de s'assurer que deux transistors ne conduisent pas exactement en même temps comme cela se fait classiquement dans une telle architecture.

Comme on l'a indiqué précédemment, on pourra clairement changer les types des transistors 10, 20, 30 et 40. On pourra alors réaliser un circuit d'interfaçage dans lequel les transistors 10 et 30 seront de type NMOS tandis que les transistors de type 20 et 40 seront de type PMOS. Plus spécialement, on réalise à cet effet la première paire de transistor au moyen d'un premier transistor de type NMOS dont l'électrode de source est connectée à un potentiel négatif (V-) et qui reçoit sur sa grille un signal de commande. La première paire comporte en outre un second transistor de type PMOS dont l'électrode de source est connectée à un potentiel positif (V+). Les deux électrodes de drain sont connectées conjointement de manière à fournir le potentiel sur l'électrode de sortie (D-). Un premier (resp. un second) condensateur de couplage est respectivement connecté entre la grille et le drain du premier (resp. second) transistor. On réalise alors le couplage capacitif croisé au moyen d'un premier (second) condensateur dont une électrode est connecté au potentiel de sortie (D+) du second circuit de commande et dont la seconde électrode est respectivement connectée à la grille du premier (resp. second) transistor.

De la même manière le second circuit comporte un troisième transistor de type NMOS ayant une électrode de grille ayant une électrode de source connectée à un potentiel négatif (V-). Le troisième transistor est monté en série avec un quatrième transistor de type PMOS dont l'électrode de source est connectée à un potentiel positif (V+) et qui présente une électrode de drain commune avec le troisième transistor, cette électrode commune étant connectée au potentiel de sortie (D+). Un troisième condensateur de couplage de sortie est connecté entre la grille et le drain du troisième transistor et, de la même manière, un quatrième condensateur de couplage de sortie est connecté entre la grille et le drain du quatrième transistor. On réalise alors le couplage capacitif croisé au moyen d'un troisième (resp. quatrième) condensateur présentant une électrode connectée au potentiel de sortie (D-) du premier circuit de commande et dont la seconde électrode est respectivement connectée à la grille du troisième (resp. quatrième) transistor.

## Revendications

1. Circuit de commande de bus comportant

   - un premier circuit comportant une première paire de transistors (10, 20) de type opposés présentant une électrode de commande et une électrode commune destinée à fournir à premier potentiel de sortie (D+) ;
   - un second circuit comportant une seconde paire de transistors (30, 40) de type opposés et présentant une électrode commune destinée à fournir un second potentiel (D-) commutant dans un sens inverse au précédent ;
   - des premiers moyens de couplage capacitifs destinés à réinjecter une fraction du signal existant audit premier potentiel (D+) dans lesdites électrode de commandes de ladite seconde paire de transistors (30, 40) et,
   - des seconds moyens de couplage capacitifs destinés à réinjecter une fraction du signal existant audit second potentiel (D-) dans lesdites électrodes de commande de ladite première paire de transistor (10, 20) de manière à provoquer une compensation des caractéristiques internes des transistors et à uniformiser les temps de montée et de descente.

2. Circuit de commande de bus selon la revendication 1 **caractérisé en ce que** le premier circuit comporte :

   - un premier transistor de type PMOS (10) présentant une électrode de grille, une électrode de source et une électrode de drain, la dite électrode de source étant connectée à un potentiel positif (V+) et la dite électrode de grille étant commandée par un premier circuit de commande ;

   - un second transistor de type NMOS (20) présentant une électrode de grille, une électrode de source et une électrode de drain, la dite électrode de source étant connectée à un potentiel négatif (V-) et la dite électrode de grille étant commandée par un second circuit de commande, les dites électrodes de drain du premier et second transistors étant connectée à une électrode commune de sortie (D+) ;

   - un premier condensateur de couplage de sortie (11) connecté entre la grille et le drain dudit premier transistor (10) ;

- un second condensateur de couplage de sortie (21) connecté entre la grille et le drain dudit second transistor (20),

lesdites électrode de grille desdits premier et second transistors étant respectivement connecté à l'électrode de sortie (D-) du circuit de commande opposé au moyen d'un premier (13) et d'un second (23) condensateur de couplage croisé.

3. Circuit de commande de bus selon la revendication 2 **caractérisé en ce que** le second circuit comporte :

   - un troisième transistor de type PMOS (30) présentant une électrode de grille, une électrode de source et une électrode de drain, la dite électrode de source étant connectée à un potentiel positif (V+) et la dite électrode de grille étant commandée par un troisième circuit de commande ;

   - un quatrième transistor de type NMOS (40) présentant une électrode de grille, une électrode de source et une électrode de drain, la dite électrode de source étant connectée à un potentiel négatif (V-) et la dite électrode de grille étant commandée par un quatrième circuit de commande, les dites électrodes de drain du troisième et dudit quatrième transistor étant connectées à une électrode commune de sortie (D-) commutant dans un sens opposée à l'électrode commune desdits premier et second transistors ;

   - un troisième condensateur de couplage de sortie (31) connecté entre la grille et le drain dudit troisième transistor (30) ;

   - un quatrième condensateur de couplage de sortie (41) connecté entre la grille et le drain dudit quatrième transistor (40),

   lesdites électrodes de grille desdits troisième et quatrième transistors étant respectivement connectées à l'électrode de sortie (D+) du premier circuit de commande au moyen d'un troisième (33) et d'un quatrième (23) condensateur de couplage croisé.

4. Circuit de commande de bus selon la revendication 3 **caractérisé en ce que** les premiers, second, troisième et quatrième condensateurs de couplage croisé présentent respectivement des valeurs C1, C2, C3 et C4 qui vérifient les relations suivantes :

$$C_1 = K \times C_2$$

$$C_3 = C_1$$

$$C_4 = C_2$$

Dans lesquelles le rapport K est égal au rapport des courants de polarisation des sources de courant attaquant respectivement ledit premier et ledit quatrième transistor.

5. Circuit de commande de bus selon la revendication 1 **caractérisé en ce que** le premier circuit comporte :

   - un premier transistor de type NMOS (10) présentant une électrode de grille, une électrode de source et une électrode de drain, la dite électrode de source étant connectée à un potentiel négatif (V-) et la dite électrode de grille étant commandée par un premier circuit de commande ;

   - un second transistor de type PMOS (20) présentant une électrode de grille, une électrode de source et une électrode de drain, la dite électrode de source étant connectée à un potentiel positif (V+) et la dite électrode de grille étant commandée par un second circuit de commande, les dites électrodes de drain du premier et second transistors étant connectée à une électrode commune de sortie (D-) ;

   - un premier condensateur de couplage de sortie (11) connecté entre la grille et le drain dudit premier transistor (10) ;

   - un second condensateur de couplage de sortie (21) connecté entre la grille et le drain dudit second transistor (20),

lesdites électrode de grille desdits premier et second transistors étant respectivement connecté à l'électrode de sortie (D+) du circuit de commande opposé au moyen d'un premier (13) et d'un second (23) condensateur de couplage croisé.

6. Circuit de commande de bus selon la revendication 2 **caractérisé en ce que** le second circuit comporte :

   - un troisième transistor de type NMOS (30) présentant une électrode de grille, une électrode de source et une électrode de drain, la dite électrode de source étant connectée à un potentiel négatif (V-) et la dite électrode de grille étant commandée par un troisième circuit de commande ;

- un quatrième transistor de type PMOS (40) présentant une électrode de grille, une électrode de source et une électrode de drain, la dite électrode de source étant connectée à un potentiel positif (V+) et la dite électrode de grille étant commandée par un quatrième circuit de commande, les dites électrodes de drain du troisième et dudit quatrième transistor étant connectées à une électrode commune de sortie (D+) commutant dans un sens opposée à l'électrode commune desdits premier et second transistors ;

- un troisième condensateur de couplage de sortie (31) connecté entre la grille et le drain dudit troisième transistor (30) ;

- un quatrième condensateur de couplage de sortie (41) connecté entre la grille et le drain dudit quatrième transistor (40),

lesdites électrodes de grille desdits troisième et quatrième transistors étant respectivement connectées à l'électrode de sortie (D-) du premier circuit de commande au moyen d'un troisième (33) et d'un quatrième (23) condensateur de couplage croisé.

7. Circuit de commande de bus selon la revendication 3 **caractérisé en ce que** les premiers, second, troisième et quatrième condensateurs de couplage croisé présentent respectivement des valeurs C1, C2, C3 et C4 qui vérifient les relations suivantes :

$$C_1 = K \times C_2$$

$$C_3 = C_1$$

$$C_4 = C_2$$

Dans lesquelles le rapport K est égal au rapport des courants de polarisation des sources de courant attaquant respectivement ledit premier et ledit quatrième transistor.

8. Circuit de commande de bus selon l'une des revendications précédentes **caractérisé en ce qu'**il comporte un dispositif permettant d'éviter la conduction simultanée des transistors de la première et de la seconde paire afin d'éviter une surconsommation d'énergie.

9. Circuit de commande de bus selon la revendication 3 ou 6 **caractérisé en ce que** lesdits premier, second, troisième et quatrième condensateur de couplage croisé sont réalisés au moyen de matrices de capacités.

10. Circuit de commande de bus selon l'une des revendications précédentes **caractérisé en ce qu'**il est adapté pour réaliser un circuit d'interfaçage pour un bus de type Universal Serial Bus.

# Figure 1

Figure 2

**Office européen des brevets**

## RAPPORT DE RECHERCHE EUROPEENNE

Numéro de la demande

EP 02 36 8096

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| Y | US 4 761 568 A (STRONSKI SABINE) 2 août 1988 (1988-08-02) | 1-3,5,6 | G06F13/40 H03K19/0948 |
| A | * colonne 2, ligne 46 - colonne 3, ligne 18 * <br> * colonne 3, ligne 63 - colonne 5, ligne 38 * <br> * abrégé; revendications 1-3; figure 1 * | 4,7-10 | |
| Y | US 3 903 431 A (HEEREN RICHARD H) 2 septembre 1975 (1975-09-02) <br> * le document en entier * | 1-3,5,6 | |
| A | EP 0 347 083 A (ADVANCED MICRO DEVICES INC) 20 décembre 1989 (1989-12-20) <br> * colonne 1, ligne 20 - colonne 2, ligne 12 * <br> * colonne 3, ligne 56 - colonne 5, ligne 6 * <br> * abrégé; revendications 1-3; figures 1,2 * | 1-10 | |
| A | US 5 736 882 A (WITTE FRANZ-OTTO) 7 avril 1998 (1998-04-07) <br> * le document en entier * | 1-10 | **DOMAINES TECHNIQUES RECHERCHES (Int.Cl.7)** <br> G06F <br> H03K |

Le présent rapport a été établi pour toutes les revendications

| Lieu de la recherche | Date d'achèvement de la recherche | Examinateur |
|---|---|---|
| LA HAYE | 1 octobre 2002 | Nguyen Xuan Hiep, C |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
& : membre de la même famille, document correspondant

EPO FORM 1503 03.82 (P04C02)

# EP 1 291 781 A1

**ANNEXE AU RAPPORT DE RECHERCHE EUROPEENNE
RELATIF A LA DEMANDE DE BREVET EUROPEEN NO.**

EP 02 36 8096

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

01-10-2002

| Document brevet cité au rapport de recherche | | Date de publication | Membre(s) de la famille de brevet(s) | | Date de publication |
|---|---|---|---|---|---|
| US 4761568 | A | 02-08-1988 | EP | 0262412 A1 | 06-04-1988 |
|  |  |  | JP | 63067915 A | 26-03-1988 |
| US 3903431 | A | 02-09-1975 | AUCUN | | |
| EP 0347083 | A | 20-12-1989 | US | 4918332 A | 17-04-1990 |
|  |  |  | AT | 116492 T | 15-01-1995 |
|  |  |  | DE | 68920208 D1 | 09-02-1995 |
|  |  |  | DE | 68920208 T2 | 29-06-1995 |
|  |  |  | EP | 0347083 A2 | 20-12-1989 |
|  |  |  | ES | 2065382 T3 | 16-02-1995 |
|  |  |  | GR | 3015601 T3 | 30-06-1995 |
|  |  |  | JP | 2039621 A | 08-02-1990 |
|  |  |  | JP | 2724331 B2 | 09-03-1998 |
| US 5736882 | A | 07-04-1998 | DE | 19548629 C1 | 24-07-1997 |
|  |  |  | EP | 0780982 A1 | 25-06-1997 |
|  |  |  | JP | 9321591 A | 12-12-1997 |

EPO FORM P0460

Pour tout renseignement concernant cette annexe : voir Journal Officiel de l'Office européen des brevets, No. 12/82